# EUROPEAN PATENT APPLICATION

(11) **EP 4 787 417 A1**
(43) Date of publication of application: **05.08.2026**
(21) Application number: 24871870.2
(22) Date of filing: 11.09.2024
(51) Int. Cl.: H01J 37/07, H01J 1/15

(54) **EMITTER**

(30) Priority: 28.09.2023 JP 2023167516
(71) Applicant: Denka Company Limited, Tokyo 103-8338 (JP)
(72) Inventor: ISHIKAWA, Daisuke, Tokyo 103-8338 (JP)
(74) Representative: Hoffmann Eitle
(86) International application number: PCT/JP2024/032596
(87) International publication number: WO 2025/070073

(57) **Abstract**

An emitter including: an electron source tip; a first filament connected to a first position on a side surface of the electron source tip; a second filament connected to a second position on a side surface of the electron source tip; two upper positive terminals to which two first side surfaces of the first filament are connected, respectively; two upper negative terminals to which two second side surfaces of the second filament are connected, respectively; one lower positive terminal electrically connected to the two upper positive terminals; one lower negative terminal electrically connected to the two upper negative terminals; and an insulator that carries the upper positive terminals, the upper negative terminals, the lower positive terminal, and the lower negative terminal, in which the first position and the second position are different positions, and the first side surfaces of the first filament are connected to side surfaces of the upper positive terminals, respectively, and the second side surfaces of the second filament are connected to side surfaces of the upper negative terminals, respectively.

## Description

### Technical Field

The present invention relates to an emitter.

### Background Art

The electron source is used in various devices such as electron beam lithography devices, electron beam drawing devices, multi-electron beam systems, scanning electron microscopes (SEM), transmission electron microscopes (TEM), electron beam microanalyzers, and microfocus X-ray devices.

For example, Patent Literature 1 discloses, for the purpose of providing an electron source that stably operates over a long period of time, an electron source including a <100> orientation single crystal rod made of tungsten or molybdenum and having an electron emission surface with a {100} crystal plane exposed at a tip end portion, a metal oxide layer covering the {100} crystal plane, a diffusion source that diffuses a raw material of the metal oxide layer, and a passage portion that is formed in the <100> orientation single crystal rod, communicates the tip end portion or the vicinity of the tip end portion from the diffusion source, and serves as a passage for diffusion of the raw material from the diffusion source.

In a case of a structure in which an electron source tip is connected to one filament as in an emitter disclosed in Patent Literature 1, the position of the electron source may gradually shift when a voltage is applied or the like, and such a positional change of the electron source tip may cause a decrease in processing accuracy or other performance degradation.

In addition, Patent Literature 2 discloses an electron gun that includes a multi-filament heater composed of a first filament connected to two positive terminals and a second filament connected to two negative terminals for the purpose of providing an electron gun that is less likely to be affected by positional deviation due to magnetism.

### Citation List

### Patent Literature

Patent Literature 1: JP 2011-065790 A
Patent Literature 2: US 2022-0076914 A

### Summary of Invention

### Technical Problem

By adopting the multi-filament heater structure as in Patent Literature 2, it is theoretically possible to minimize positional deviation due to magnetism. However, when each filament is formed on an upper surface of a terminal, the contact point between the filament and the terminal is small and fragile, making it difficult to suppress positional deviation due to magnetism over a long period of time.

In addition, Patent Literature 2 discloses an aspect having four upper terminals, and it is presumed that the number of lower terminals in the aspect is also four. However, since some devices utilizing an emitter correspond to devices including two lower terminals, a novel structure having four upper terminals with respect to two lower terminals is demanded.

The present invention has been made in view of the above problems, and an object thereof is to provide an electron source having excellent positional stability of an electron source tip during the use, and a method for manufacturing the same.

### Solution to Problem

That is, the present invention is as follows.
[1] An emitter including:
   an electron source tip;
   a first filament connected to a first position on a side surface of the electron source tip;
   a second filament connected to a second position on a side surface of the electron source tip;
   two upper positive terminals to which two first side surfaces of the first filament are connected, respectively;
   two upper negative terminals to which two second side surfaces of the second filament are connected, respectively;
   one lower positive terminal electrically connected to the two upper positive terminals;
   one lower negative terminal electrically connected to the two upper negative terminals; and
   an insulator that carries the upper positive terminals, the upper negative terminals, the lower positive terminal, and the lower negative terminal, in which
   the first position and the second position are different positions, and
   the first side surfaces of the first filament are connected to side surfaces of the upper positive terminals, respectively, and
   the second side surfaces of the second filament are connected to side surfaces of the upper negative terminals, respectively.
[2] The emitter according to [1], in which
   in a plan view of a first surface orthogonal to a tip end direction of the electron source tip,
   the two upper positive terminals and the two upper negative terminals are disposed such that a line segment connecting centers of the two upper positive terminals intersects a line segment connecting centers of the two upper negative terminals.
[3] The emitter according to [1] or [2], in which
   in a plan view of a first surface orthogonal to a tip end direction of the electron source tip,
   the first filament and the second filament are arranged so as to intersect each other.
[4] The emitter according to [3], in which
   in the plan view of the first surface,
   an angle θ1 formed by the projection line of the first filament and the projection line of the second filament is 80° or more and 90° or less.
[5] The emitter according to [3], in which
   in the plan view of the first surface,
   an angle θ1 formed by the projection line of the first filament and the projection line of the second filament is less than 80°.
[6] The emitter according to any one of [1] to [5], in which
   in a plan view of a first surface orthogonal to a tip end direction of the electron source tip,
   the first filament is arranged such that a line segment connecting the side surfaces of the two upper positive terminals to which the first side surfaces of the first filament are connected intersects a line segment connecting centers of the two upper positive terminals.
[7] The emitter according to any one of [1] to [6], in which
   in a plan view of a first surface orthogonal to a tip end direction of the electron source tip,
   the second filament is arranged such that a line segment connecting the side surfaces of the two upper negative terminals to which the second side surfaces of the second filament are connected intersects a line segment connecting centers of the two upper negative terminals.
[8] The emitter according to any one of [1] to [5], and [7], in which
   in a plan view of a first surface orthogonal to a tip end direction of the electron source tip,
   the first filament is arranged such that a line segment connecting the side surfaces of the two upper positive terminals to which the first side surfaces of the first filament are connected does not intersect a line segment connecting centers of the two upper positive terminals.
[9] The emitter according to any one of [1] to [6], and [8], in which
   in a plan view of a first surface orthogonal to a tip end direction of the electron source tip,
   the second filament is arranged such that a line segment connecting the side surfaces of the two upper negative terminals to which the second side surfaces of the second filament are connected does not intersect a line segment connecting centers of the two upper negative terminals.
[10] The emitter according to any one of [1] to [9], in which
   in a plan view of a first surface orthogonal to a tip end direction of the electron source tip,
   the first filament and the second filament are arranged such that the side surfaces of the upper positive terminals to which the first side surfaces of the first filament are connected and the side surfaces of the upper negative terminals to which the second side surfaces of the second filament are connected at least face each other.
[11] The emitter according to any one of [1] to [9], in which
   in a plan view of a first surface orthogonal to a tip end direction of the electron source tip,
   the first filament and the second filament are arranged such that the side surfaces of the upper positive terminals to which the first side surfaces of the first filament are connected and the side surfaces of the upper negative terminals to which the second side surfaces of the second filament are connected do not face each other.
[12] The emitter according to any one of [1] to [11], in which
   the first filament is bonded at a position closer to a tip end of the electron source tip than the second filament.
[13] The emitter according to any one of [1] to [11], in which
   the second filament is bonded at a position closer to a tip end of the electron source tip than the first filament.
[14] The emitter according to any one of [1] to [13], in which
   a pair of the upper positive terminals includes a positive terminal coupling part that electrically connects the pair of the upper positive terminals, and
   a pair of the upper negative terminals includes a negative terminal coupling part that electrically connects the pair of the upper negative terminals.

### Advantageous Effects of Invention

According to the present invention, it is possible to provide the emitter having excellent positional stability of the electron source tip during the use.

### Brief Description of Drawings

[Figure 1]Fig. 1 shows a schematic perspective view of an emitter of the present embodiment.
[Figure 2]Fig. 2 shows a top view of an insulator as viewed in plan from the electron source tip side on a first surface orthogonal to the tip end direction of an electron source tip.
[Figure 3A]Fig. 3A shows a top view of an insulator as viewed in plan from the electron source tip side on a first surface orthogonal to the tip end direction of an electron source tip.
[Figure 3B]Fig. 3B shows a top view of an insulator as viewed in plan from the electron source tip side on a first surface orthogonal to the tip end direction of an electron source tip.
[Figure 4]Fig. 4 shows a top view of an insulator as viewed in plan from the electron source tip side on a first surface orthogonal to the tip end direction of an electron source tip.

### Description of Embodiments

Hereinafter, an embodiment of the present invention (hereinafter, referred to as "the present embodiment") will be described in detail with reference to the drawings as necessary, but the present invention is not limited thereto, and can be modified in various ways without departing from the gist of the invention. Note that the dimensional ratios in the drawings are not limited to the illustrated ratios.

In the present embodiment, "X direction", "Y direction", "Z direction", and "XY plane direction" are defined as necessary. Here, the "Z direction" is a direction parallel to a direction in which electrons are emitted from the tip end of an electron source tip 10. A direction in which electrons are emitted from the tip end of the electron source tip 10 is also referred to as a "Z+ direction", and a direction opposite to the Z+ direction is also referred to as a "Z- direction". Unless otherwise specified, the "Z direction" is parallel to a direction in which an upper terminal 20 and a lower terminal 30 extend.

In addition, the "XY plane direction" is a plane direction intersecting the Z direction. The XY plane direction may be parallel to a surface 40a from which the upper terminal 20 of an insulator 40 extends and a surface 40b from which the lower terminal 30 extends. In addition, unless otherwise specified, the Z direction may be orthogonal to the XY plane direction. The "X direction" and the "Y direction" are directions intersecting each other in the XY plane. The "X direction " refers to a direction connecting the centers of upper positive terminals 20a and 20b, and the "Y direction" refers to a direction connecting the centers of the upper negative terminals 20c and 20d. The X direction and the Y direction may not be orthogonal to each other.

Terms meaning shape and/or geometric conditions need not be bound by strict meaning and may be construed to include a range that may expect similar functionality. For example, "parallel" and/or "orthogonal" or other terms correspond to the above terms.

When a configuration is expressed as being "on", "below", "upper side", "lower side", "upward", or "downward" of another configuration, an aspect in which a configuration is in direct contact with the other configuration and an aspect in which another configuration is included between one configuration and the other configuration may be included. In other words, the aspect in which another configuration is included between one configuration and the other configuration may be expressed as that the one configuration is indirectly in contact with the other configuration. Also, the expression "on", "upper side" or "upward" is interchangeable with the expression "below", "lower side" or "downward". In other words, the vertical direction may be reversed. The same applies to the right and left sides.

When the same reference numerals or similar reference numerals are given to the same portions and/or portions having similar functions, repeated description may be omitted. In addition, dimensional ratios in the drawings may be different from actual ratios. Furthermore, a part of the configuration of the embodiment may be omitted from the drawings.

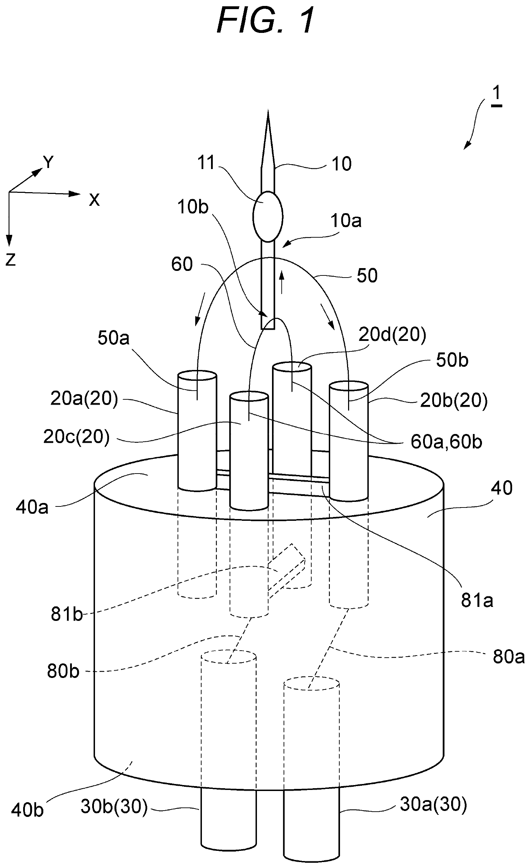

Fig. 1 shows an emitter 1 of the present embodiment. As shown in Fig. 1, the emitter 1 of the present embodiment includes an electron source tip 10, a first filament 50 connected to a first position 10a on a side surface of the electron source tip 10, a second filament 60 connected to a second position 10b on a side surface of the electron source tip 10, two upper positive terminals 20a and 20b to which two first side surfaces 50a and 50b of the first filament 50 are connected, respectively, two upper negative terminals 20c and 20d to which two second side surfaces 60a and 60b of the second filament are connected, respectively, one lower positive terminal 30a electrically connected to the two upper positive terminals 20a and 20b, one lower negative terminal 30b electrically connected to the two upper negative terminals 20c and 20d, and an insulator 40 that carries the upper positive terminals 20a and 20b, the upper negative terminals 20c and 20d, the lower positive terminal 30a, and the lower negative terminal 30b.

Note that the upper positive terminals 20a and 20b and the upper negative terminals 20c and 20d are also collectively referred to as an "upper terminal 20". The lower positive terminal 30a and the lower negative terminal 30b are also collectively referred to as a "lower terminal 30". Hereinafter, each configuration of the emitter 1 of the present embodiment will be described in more detail.

The electron source tip 10 is a material that emits electrons by heating and application of an electric field, and may have an electron emission surface from which electrons are emitted at the tip end. The electron emission material is not particularly limited, and examples thereof include at least one or more selected from the group consisting of tungsten, molybdenum, tantalum, rhenium, lanthanum boride such as LaB₆, cerium boride such as CeB₆, and iridium cerium such as Ir₂Ce.

In addition, the electron source tip may include a diffusion source 11. The diffusion source 11 is not particularly limited, and examples thereof include composite oxides of barium oxide and scandium oxide.

The first filament 50 and the second filament 60 are connected to the electron source tip 10 as filaments for heating the electron source tip 10. More specifically, the first filament 50 and the second filament 60 may be connected to a heating power supply via the upper terminal 20 and the lower terminal 30, and the electron source tip 10 may be heated by a current flowing from the heating power supply. The current flowing through the first filament 50 and the second filament 60 may be set such that the electron source is about 1800 K, for example.

Fig. 1 shows an aspect in which the first filament 50 is bonded to a position closer to the tip end of the electron source tip 10 than the second filament 60, but the present invention is not limited thereto, and the second filament 60 may be bonded to a position closer to the tip end of the electron source tip 10 than the first filament 50.

The distance between the first position 10a on the side surface of the electron source tip 10 to which the first filament 50 is connected and the second position 10b on the side surface of the electron source tip 10 to which the second filament 60 is connected is preferably 10 to 500 µm and may be 50 to 300 µm, in which the distance refers to a distance of a gap between the first filament 50 and the second filament 60.

In addition, as the first filament 50 and the second filament 60, a tungsten or graphite filament, a carbon heater, or the like may be used. The materials constituting the first filament 50 and the second filament 60 may also be the same as or different from each other.

The first side surfaces 50a and 50b of the first filament 50 are connected to the two upper positive terminals 20a and 20b, respectively, and any portion between the first side surfaces 50a and 50b is connected to the first position 10a on the side surface of the electron source tip 10. In addition, the second side surfaces 60a and 60b of the second filament 60 are connected to the two upper negative terminals 20c and 20d, respectively, and any portion between the second side surfaces 60a and 60b is connected to the second position 10b on the side surface of the electron source tip 10.

As shown in Fig. 1, in the emitter 1 of the present embodiment, two upper positive terminals 20a and 20b and one lower positive terminal 30a are electrically connected, and two upper negative terminals 20c and 20d and one lower negative terminal 30b are electrically connected. Thus, the emitter 1 has a structure that converts the two lower terminals 30 into the four upper terminals 20.

Although a connection aspect between the two upper positive terminals 20a and 20b and the one lower positive terminal 30a is not particularly limited, examples thereof include a connection aspect in which each of the two upper positive terminals 20a and 20b is connected to the lower positive terminal 30a; and as shown in Fig. 1, an aspect in which one upper positive terminal 20b is connected to the lower positive terminal 30a, and the upper positive terminal 20a and the upper positive terminal 20b are coupled to each other.

Here, a connection part between the upper positive terminals 20a and 20b and the lower positive terminal 30a is referred to as an upper and lower positive terminal coupling part 80a, and a coupling part electrically connecting the pair of upper positive terminals 20a and 20b is referred to as an upper positive terminal coupling part 81a.

Although a connection aspect between the two upper negative terminals 20c and 20d and the one lower negative terminal 30b is not particularly limited, examples thereof include an aspect in which the two upper negative terminals 20c and 20d are connected to the lower negative terminal 30b; and as shown in Fig. 1, an aspect in which one upper negative terminal 20c is connected to the lower negative terminal 30b, and the upper negative terminal 20c and the upper negative terminal 20d are coupled to each other.

Here, a connection part between the upper negative terminals 20c and 20d, and the lower negative terminal 30b is referred to as an upper and lower negative terminal coupling part 80b, and a coupling part electrically connecting the pair of upper negative terminals 20c and 20d is referred to as an upper negative terminal coupling part 81b.

In the example shown in Fig. 1, the upper positive terminal coupling part 81a is positioned on the surface of the insulator 40 in the Z+ direction, and the upper negative terminal coupling part 81b is positioned in the insulator 40, but the present invention is not limited thereto; in addition to the upper positive terminal coupling part 81a, the upper negative terminal coupling part 81b may also be positioned on the surface of the insulator 40 in the Z+ direction so as to bypass the upper positive terminal coupling part 81a and the upper positive terminals 20a and 20b.

With the above structure, during heating, electrons are supplied from the lower negative terminal 30b to the two upper negative terminals 20c and 20d, and electrons are supplied from the second side surfaces 60a and 60b of the second filament 60 toward the second position 10b on the side surface of the electron source tip 10. Then, electrons flow from the first position 10a on the side surface of the electron source tip 10 toward the first side surfaces 50a and 50b of the first filament 50, and electrons flow from the upper positive terminals 20a and 20b toward the lower positive terminal 30a.

The emitter 1 of the present embodiment has a structure in which filaments are stretched across the two upper positive terminals 20a and 20b and the two upper negative terminals 20c and 20d, and the electron source tip 10 is supported by the two filaments. Therefore, the electron source tip is more stably held as compared with a structure in which the electron source tip 10 is supported by one filament connecting the positive terminal and the negative terminal.

An electron gun includes a magnetic lens that forms a magnetic field and the emitter 1. As a result, electrons can be emitted from the tip end of the emitter 1 toward a target through the magnetic lens. In this case, since the emitter 1 is arranged in a magnetic field formed by the magnetic lens, a magnetic force acts on the filaments by the magnetic field. As a result, positional deviation of the emitter 1 occurs, and there is a possibility that positional stability of the electron source tip is impaired.

In particular, since the magnetic repulsion easily acts in the XY plane direction, the positional stability of the electron source tip may be further impaired in a case where the first side surfaces 50a and 50b of the first filament 50 are in contact with the upper surfaces of the two upper positive terminals 20a and 20b and the contact area is small, or in a case where the second side surfaces 60a and 60b of the second filament 60 are in contact with the upper surfaces of the two upper negative terminals 20c and 20d and the contact area is small.

On the other hand, in the present embodiment, the first side surfaces 50a and 50b of the first filament 50 are connected to the side surfaces 20a' and 20b' of the upper positive terminals 20a and 20b, respectively, and the second side surfaces 60a and 60b of the second filament 60 are connected to the side surfaces 20c' and 20d' of the upper negative terminals 20c and 20d, respectively.

A method of connecting the side surfaces of the filaments and the side surfaces of the terminals is not particularly limited, but for example, spot welding can be used.

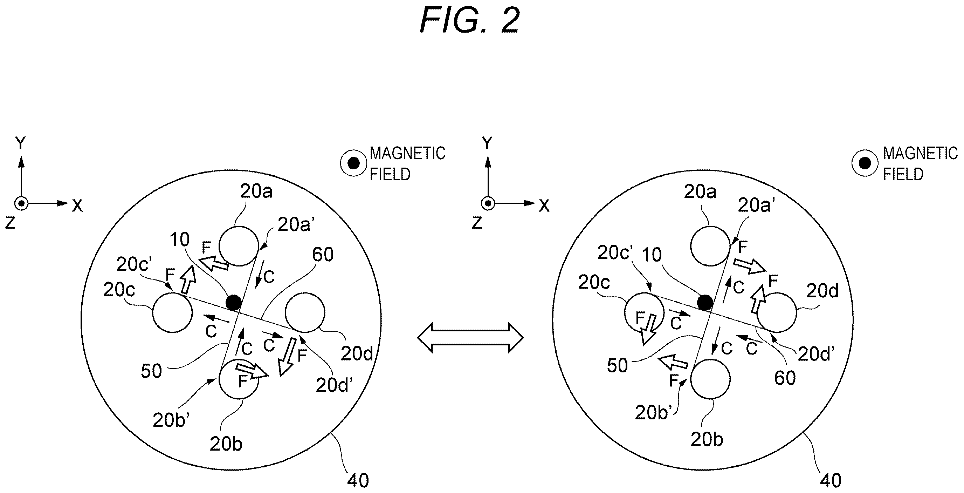

Fig. 2 shows a plan view of the insulator 40 as viewed in a Z- direction from the electron source tip 10 side. Fig. 2 shows a current flow indicated by arrow C and direction F of a force generated at that time. As shown in Fig. 2, the first side surfaces 50a and 50b of the first filament 50 are connected to the side surfaces 20a' and 20b' of the upper positive terminals 20a and 20b, respectively, and the second side surfaces 60a and 60b of the second filament 60 are connected to the side surfaces 20c' and 20d' of the upper negative terminals 20c and 20d, respectively. As a result, it can be seen that the magnetic force in the XY plane direction received by the filament is antagonized in the magnetic field formed by the magnetic lens. As shown on the left and right sides of Fig. 2, this antagonistic relationship is similarly established even when the current is reversely passed.

In addition, by bonding an end portion of the filament to the side surface in this manner, a contact area between the first side surfaces 50a and 50b and the upper positive terminals 20a and 20b and a contact area between the second side surfaces 60a and 60b and the upper negative terminals 20c and 20d further increase. Therefore, the connection between the first filament 50 and the upper positive terminals 20a and 20b and the connection between the second filament 60 and the upper negative terminals 20c and 20d are made stronger, and the position change when used for a long time can also be minimized.

In addition, by connecting the first side surfaces 50a and 50b to the side surfaces 20a' and 20b' and connecting the second side surfaces 60a and 60b to the side surfaces 20c' and 20d', the upper terminal 20 can support the first filament 50 and the second filament 60 against the magnetic force even though the filaments receive the magnetic force in the XY plane direction in the magnetic field formed by the magnetic lens. For example, as shown on the right side in Fig. 2, at the upper positive terminal 20a, a force F by the first filament 50 is applied to the side surface 20a', and the upper positive terminal 20a supports the first filament 50.

Therefore, the positional stability of the electron source tip is further improved. As a result, when the emitter is used in various devices such as electron beam lithography devices, electron beam drawing devices, multi-electron beam systems, scanning electron microscopes (SEM), transmission electron microscopes (TEM), electron beam microanalyzers, and microfocus X-ray devices, the irradiation position accuracy of an electron beam is further improved.

The insulator 40 of the present embodiment is not particularly limited, and examples thereof include alumina. The adhesion of the upper terminal 20 and the lower terminal 30 to the insulator 40 is not particularly limited, but may be performed by brazing or the like, for example.

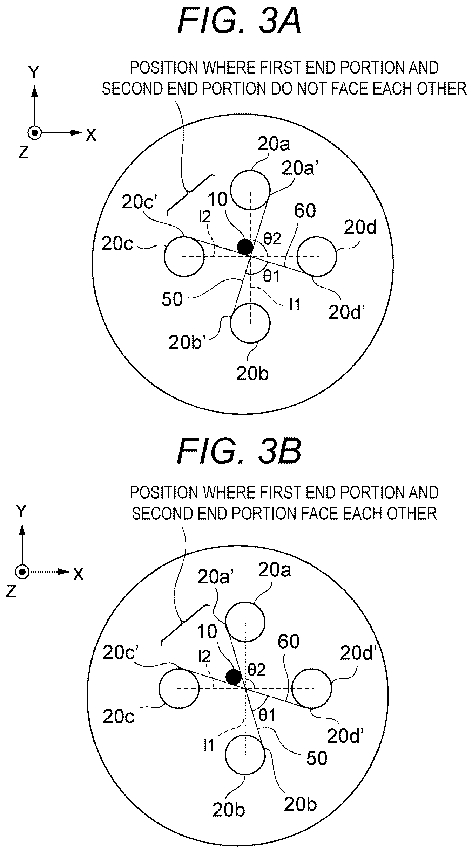

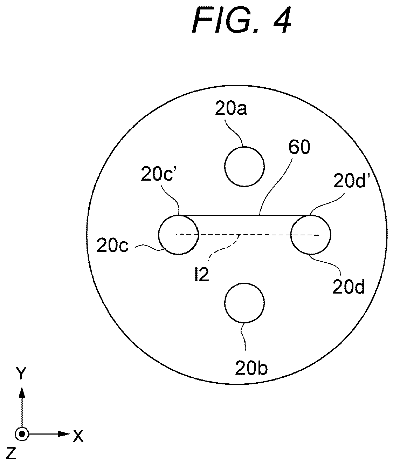

Hereinafter, aspects of the emitter 1 of the present embodiment will be further described with reference to Figs. 3 to 4. Figs. 3 and 4 show top views of insulators 40 as viewed in plan from the electron source tip 10 side on a first surface orthogonal to the tip end direction of the electron source tip 10. Note that the first plane is synonymous with the "XY plane".

In plan view of the first surface, the projection lines of the first filament 50 and the second filament 60 on the first surface are preferably arranged so as to intersect each other. As shown in Fig. 3A, an angle θ1 formed by the projection line of the first filament 50 and the projection line of the second filament 60 is 80° or more and 90° or less, 82° or more and 90° or less, and may be 84° or more and 90° or less. As shown in Fig. 3B, on the first surface, the angle θ1 formed by the projection line of the first filament 50 and the projection line of the second filament 60 is preferably less than 80°, 10° or more and 75° or less, 20° or more and 70° or less, and may be 30° or more and 65° or less.

In the present embodiment, the "plan view" means that the first surface is viewed from a surface along the first surface. In a plan view of the first surface, the first filament 50 and the second filament 60 are projected onto the first surface.

As shown in Fig. 3A, in a plan view of the first surface, the two upper positive terminals 20a and 20b and the two upper negative terminals 20c and 20d may be arranged such that a line segment l1 connecting the centers of the two upper positive terminals 20a and 20b and a line segment l2 connecting the centers of the two upper negative terminals 20c and 20d intersect each other.

An angle θ2 formed by the line segment l1 and the line segment l2 is preferably 80° or more and 90° or less, 82° or more and 90° or less, and may be 84° or more and 90° or less. The angle θ2 is preferably less than 80°, 10° or more and 75° or less, 20° or more and 70° or less, and may be 30° or more and 65° or less.

As shown in Figs. 3A and 3B, in a plan view of the first surface, the first filament 50 may be arranged such that a line segment connecting the side surfaces 20a' and 20b' of the two upper positive terminals 20a and 20b to which the first side surfaces 50a and 50b of the first filament 50 are connected intersects a line segment l1 connecting the centers of the two upper positive terminals 20a and 20b. Note that the line segment connecting the side surfaces 20a' and 20b' herein is equal in length to the first filament 50.

As shown in Figs. 3A and 3B, in a plan view of the first surface, the second filament 60 may be arranged such that a line segment connecting the side surfaces 20c 'and 20d' of the two upper negative terminals 20c and 20d to which the second side surfaces 60a and 60b of the second filament 60 are connected intersects a line segment l2 connecting the centers of the two upper negative terminals 20c and 20d. Note that the line segment connecting the side surfaces 20c' and 20d' herein is equal to the second filament 60.

In a plan view of the first surface, the first filament 50 may be arranged such that the line segment connecting the side surfaces 20a' and 20b' of the two upper positive terminals 20a and 20b to which the first side surfaces 50a and 50b of the first filament 50 are connected does not intersect the line segment l1 connecting the centers of the two upper positive terminals. Note that the line segment connecting the side surfaces 20a' and 20b' herein is equal in length to the first filament 50.

As shown in Fig. 4, in a plan view of the first surface, the second filament 60 may be arranged such that the line segment connecting the side surfaces 20c 'and 20d' of the two upper negative terminals 20c and 20d to which the second side surfaces 60a and 60b of the second filament 60 are connected does not intersect the line segment l2 connecting the centers of the two upper negative terminals. Note that the line segment connecting the side surfaces 20c' and 20d' herein is equal to the second filament 60. Note that, in Fig. 4, the first filament 50 and the like are omitted.

As shown in Fig. 3B, in a plan view of the first surface, the first filament 50 and the second filament 60 may be arranged such that the side surfaces 20a' and 20b' of the upper positive terminals 20a and 20b to which the first side surfaces 50a and 50b of the first filament 50 are connected and the side surfaces 20c' and 20d' of the upper negative terminals 20c and 20d to which the second side surfaces 60a and 60b of the second filament 60 are connected may at least face each other. Here, "at least face each other" means that the side surface 20a' and the side surface 20c' may face each other as shown in Fig. 3B, for example, and it is not necessary that the side surface 20a' and the side surface 20d' face each other.

As shown in Fig. 3A, in a plan view of the first surface, the first filament 50 and the second filament 60 may be arranged such that the side surfaces 20a' and 20b' of the upper positive terminals 20a and 20b to which the first side surfaces 50a and 50b of the first filament 50 are connected and the side surfaces 20c' and 20d' of the upper negative terminals 20c and 20d to which the second side surfaces 60a and 60b of the second filament 60 are connected do not face each other.

### Industrial Applicability

The present invention has industrial applicability as an emitter.

### Reference Signs List

- 1: Emitter
- 10: Electron source tip
- 10a: First position
- 10b: Second position
- 11: Diffusion source
- 20: Upper terminal
- 20a: Upper positive terminal
- 20a': Side surface
- 20b: Upper positive terminal
- 20b': Side surface
- 20c: Upper negative terminal
- 20c': Side surface
- 20d: Upper negative terminal
- 20d': Side surface
- 30: Lower terminal
- 30a: Lower positive terminal
- 30b: Lower negative terminal
- 40: Insulator
- 40a: Surface
- 40b: Surface
- 50: first filament
- 50a: First side surface
- 50b: First side surface
- 60: Second filament
- 60a: Second side surface
- 60b: Second side surface
- 80a: Upper and lower positive terminal coupling part
- 80b: Upper and lower negative terminal coupling part
- 81a: Upper positive terminal coupling part
- 81b: Upper negative terminal coupling part

## Claims

1. An emitter comprising:
an electron source tip;
a first filament connected to a first position on a side surface of the electron source tip;
a second filament connected to a second position on a side surface of the electron source tip;
two upper positive terminals to which two first side surfaces of the first filament are connected, respectively;
two upper negative terminals to which two second side surfaces of the second filament are connected, respectively;
one lower positive terminal electrically connected to the two upper positive terminals;
one lower negative terminal electrically connected to the two upper negative terminals; and
an insulator that carries the upper positive terminals, the upper negative terminals, the lower positive terminal, and the lower negative terminal, wherein
the first position and the second position are different positions, and
the first side surfaces of the first filament are connected to side surfaces of the upper positive terminals, respectively, and
the second side surfaces of the second filament are connected to side surfaces of the upper negative terminals, respectively.

2. The emitter according to claim 1, wherein
in a plan view of a first surface orthogonal to a tip end direction of the electron source tip,
the two upper positive terminals and the two upper negative terminals are arranged such that a line segment connecting centers of the two upper positive terminals intersects a line segment connecting centers of the two upper negative terminals.

3. The emitter according to claim 1, wherein
in a plan view of a first surface orthogonal to a tip end direction of the electron source tip,
a projection line of the first filament and a projection line of the second filament onto the first surface are arranged so as to intersect each other.

4. The emitter according to claim 3, wherein
in the plan view of the first surface,
an angle θ1 formed by the projection line of the first filament and the projection line of the second filament is 80° or more and 90° or less.

5. The emitter according to claim 3, wherein
in the plan view of the first surface,
an angle θ1 formed by the projection line of the first filament and the projection line of the second filament is less than 80°.

6. The emitter according to claim 1, wherein
in a plan view of a first surface orthogonal to a tip end direction of the electron source tip,
the first filament is arranged such that a line segment connecting the side surfaces of the two upper positive terminals to which the first side surfaces of the first filament are connected intersects a line segment connecting centers of the two upper positive terminals.

7. The emitter according to claim 1, wherein
in a plan view of a first surface orthogonal to a tip end direction of the electron source tip,
the second filament is arranged such that a line segment connecting the side surfaces of the two upper negative terminals to which the second side surfaces of the second filament are connected intersects a line segment connecting centers of the two upper negative terminals.

8. The emitter according to claim 1, wherein
in a plan view of a first surface orthogonal to a tip end direction of the electron source tip,
the first filament is arranged such that a line segment connecting the side surfaces of the two upper positive terminals to which the first side surfaces of the first filament are connected does not intersect a line segment connecting centers of the two upper positive terminals.

9. The emitter according to claim 1, wherein
in a plan view of a first surface orthogonal to a tip end direction of the electron source tip,
the second filament is arranged such that a line segment connecting the side surfaces of the two upper negative terminals to which the second side surfaces of the second filament are connected does not intersect a line segment connecting centers of the two upper negative terminals.

10. The emitter according to claim 1, wherein
in a plan view of a first surface orthogonal to a tip end direction of the electron source tip,
the first filament and the second filament are arranged such that the side surfaces of the upper positive terminals to which the first side surfaces of the first filament are connected and the side surfaces of the upper negative terminals to which the second side surfaces of the second filament are connected at least face each other.

11. The emitter according to claim 1, wherein
in a plan view of a first surface orthogonal to a tip end direction of the electron source tip,
the first filament and the second filament are arranged such that the side surfaces of the upper positive terminals to which the first side surfaces of the first filament are connected and the side surfaces of the upper negative terminals to which the second side surfaces of the second filament are connected do not face each other.

12. The emitter according to claim 1, wherein
the first filament is bonded at a position closer to a tip end of the electron source tip than the second filament.

13. The emitter according to claim 1, wherein
the second filament is bonded at a position closer to a tip end of the electron source tip than the first filament.

14. The emitter according to claim 1, wherein
a pair of the upper positive terminals includes a positive terminal coupling part that electrically connects the pair of the upper positive terminals, and
a pair of the upper negative terminals includes a negative terminal coupling part that electrically connects the pair of the upper negative terminals.
